# EUROPEAN PATENT SPECIFICATION

(11) **EP 0 649 152 B1**
(45) Date of publication and mention of the grant of the patent: **25.11.1998**
(21) Application number: 95100214.6
(22) Date of filing: 17.08.1990
(51) Int. Cl.: H01F 17/00, H01F 27/28, H01F 41/04, H01L 27/08

(54) **Transformer integrable with a semiconductor integrated circuit and method for producing thereof**
Transformator integrierbar mit integriertem halbleitendem Kreis und sein Herstellungsverfahren
Transformateur intégrable avec un circuit intégré semi-conducteur et sa méthode de fabrication

(30) Priority: 18.08.1989 JP 213839/89
(43) Date of publication of application: 19.04.1995
(62) Divisional of application: 90115799.0
(73) Proprietor: MITSUBISHI DENKI KABUSHIKI KAISHA, Tokyo (JP)
(72) Inventor: Andoh, Naoto, c/o Mitsubishi Denki KK, Optoelec., Itami-shi, Hyogo-ken (JP); Inoue, Akira, c/o Mitsubishi Denki KK, Optoelec., Itami-shi, Hyogo-ken (JP); Nakajima, Yasuharu, c/o Mitsub. Denki KK, Optoelec, Itami-shi, Hyogo-ken (JP); Nakahara, Kazuhito, c/o Mitsub. Denki KK, Optoelec, Itami-shi, Hyogo-ken (JP)
(74) Representative: TER MEER STEINMEISTER & PARTNER GbR

(56) References cited:
- US-A- 3 881 244
- US-A- 4 071 378
- US-A- 4 080 585

## Description

The present invention relates to a method for producing a transformer as described in claim 1.

From US 4,071,378 a transformer of the kind mentioned above and a method for producing thereof are already known according to which the following process steps are carried out: Forming a plurality of droplets of a selective metal on a selective portion of a major surface area of a body of semiconductor material having two major opposed surfaces; establishing a thermal gradient substantially along an axis of the body perpendicular to the two major opposed surfaces; thermal migrating the plurality of droplets of selective metal through the body in the direction of the higher temperature of the thermal gradient from the one major surface to the, and terminating in, the other ofthe two major opposed surfaces to form a plurality of regions of recrystallized material of the body each having two opposed end surfaces, each end surface being coextensive with only one of the two major surfaces, solid solubility of the selective metal therein and a second and opposite type conductivity than the body and also forming a P-N junction at the contiguous surfaces of each ofthe regions and the body; affixing electrical contact means to selective end surfaces of selective regions to form a series circuit thereof to function as a primary winding of a transformer; and affixing electrical contact means to selective end surfaces of the remainder ofthe regions to form a series circuit thereof to function as a secondary winding of the same transformer. The electrical contact means for the primary winding are deposited on layers of electrically insulating material disposed on the respective surfaces of the semiconductor body, whereas the electrical contact means for the secondary windings are formed on electrical insulating layers disposed on the respective layers mentioned above.

US 3 881 244 discloses a solid state inductor formed in a monocristalline semiconductor body. The inductor comprises an electrically insulated helix having metallic vias disposed in corresponding via holes and electrical conductors disposed on an insulating film covering the semiconductor body. Each of these conductors electrically connects respective pairs of vias.

It is an object of the present invention to provide a suitable method for producing a transformer integrable in a semiconductor integrated circuit that has a relatively high mutual inductance between its windings while occupying a relatively small area and volume.

This object is solved by the method according to claim 1.

Figures 1(a), 1(b), 1(c), 1(d), and 1(e) are a perspective views, two side views, a partial exploded view, and another partial view, respectively, of a transformer according to an embodiment of the invention, whereas

Figures 2(a) and 2(b) are two side views of a modification of the transformer of Figure 1(a) according to an embodiment of the invention.

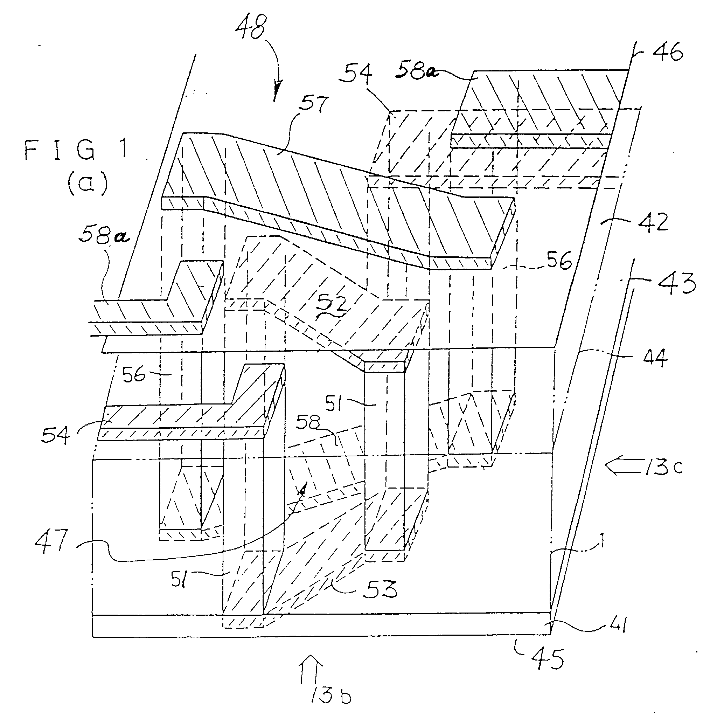

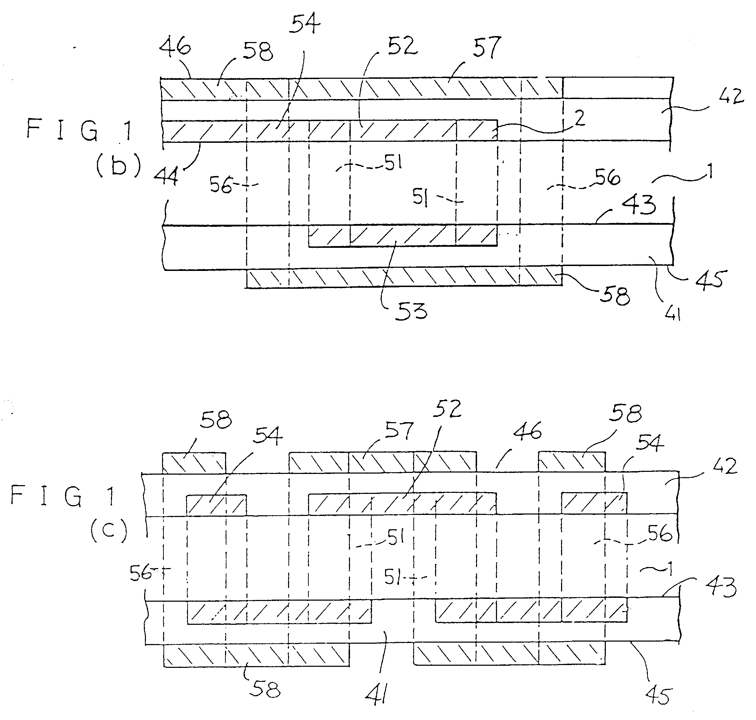

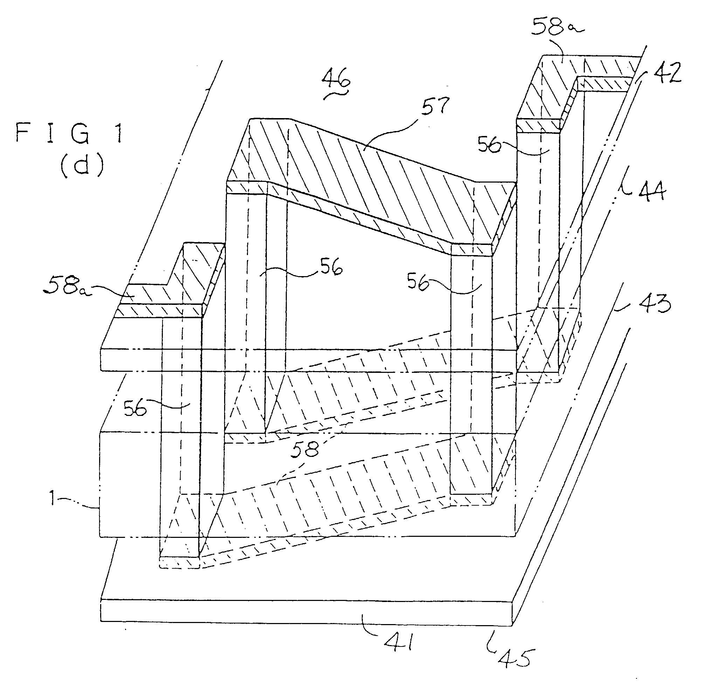

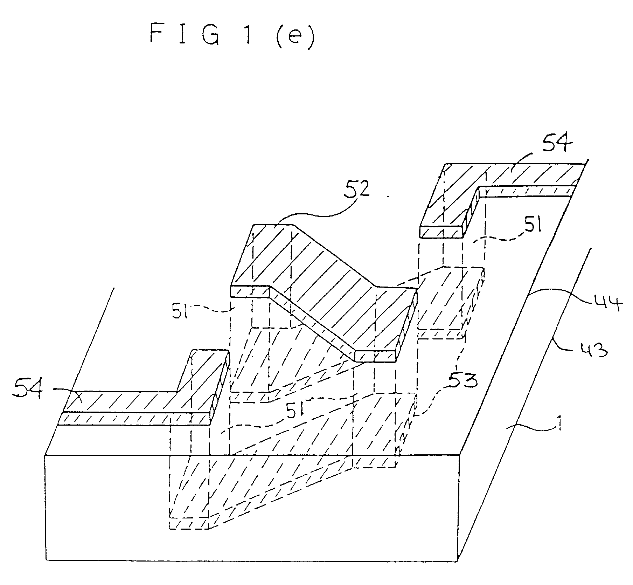

A transformer embodiment according to the invention is shown in Figures 1(a)-1(e). This transformer embodiment incorporates a first generally helical coil 47 surrounded by a second generally helical coil 48. The term "helical" as used here refers to a three-dimensional winding much like a wire wound around a spool along the length of the spool. However, the term as used here encompasses a winding that includes corners along its length.

Figure 1(a) shows a perspective view of an embodiment of the invention and Figures 1(b) and 1(c) show side views of the structure of the Figure 1(a). These views include a large number of phantom lines and overlapping elements which may be more easily understood by reference to Figures 1(d) and 1(e). Turning initially to Figure 1(e), an electrically insulating substrate 1 includes a plurality of via holes that penetrate the substrate 1 from a surface 43 to a surface 44 and are filled with an electrically conducting material, such as a metal. Substrate 1 may be a semiconductor, such as gallium arsenide or indium phosphide. Pairs of vias 51 are electrically connected on surface 43 of substrate 1 by electrical conductors 53. Likewise, in the embodiment shown in Figure 1(e), an electrical conductor 52 disposed on surface 44 of the substrate electrically connects two of the vias 51 on surface 44. The substrate 1 of Figure 1(e) includes four vias 51, but a larger number could be employed in the invention in which case more conductors 52 on surface 44 would be employed. Two of the vias 51 are connected to respective leads 54 disposed on surface 44. Thus, as is apparent from Figure 1(e), a helical, inductive structure, much like a wound coil, as shown in Figure 1(e) is initially prepared.

The helical structure 48 that surrounds helical structure 47 is most easily understood with respect to Figure 1(d). Figure 1(d) is an exploded view and omits the helical structure 47 for clarity. After the formation of helical structure 47, electrically insulating layers 41 and 42 are placed on the surfaces 43 and 44 of substrate 1. The insulating layers 41 and 42 cover the electrical conductors 53 and 52, respectively. Thereafter, electrically conducting vias 56 are produced, penetrating insulating layers 41 and 42 as well as substrate 1. Pairs of vias exposed at surface 45 of insulating layer 41 are electrically interconnected by electrical conductors 58. On surface 46 of electrically insulating layer 42, a conductor 57 interconnects two of the vias 56. Again, only one conductor 57 is shown, but, in other embodiments including more vias 56, additional conductors 57 would be employed. Electrical leads 58a disposed on surface 46 respectively contact one of the vias 56 to produce external leads for the structure. When these two helices are completed, the structure of Figure 1(a) is obtained.

All of the steps in producing the transformer structure of Figure 1(a) are conventional. The via holes can be produced by an isotropic etching, such as ion milling or reactive ion etching. The filling of the via holes with metal and the deposition and patterning of the electrical interconnections illustrated uses conventional technology. While helix 48 is shown surrounding helix 47, which maximizes the inductive coupling between the helices, it is not necessary that one coil completely surrounds the other or that the helices be coaxial. Moreover, portions or all of the insulating films 41 and 42 may be removed, leaving air bridge type structures in place.

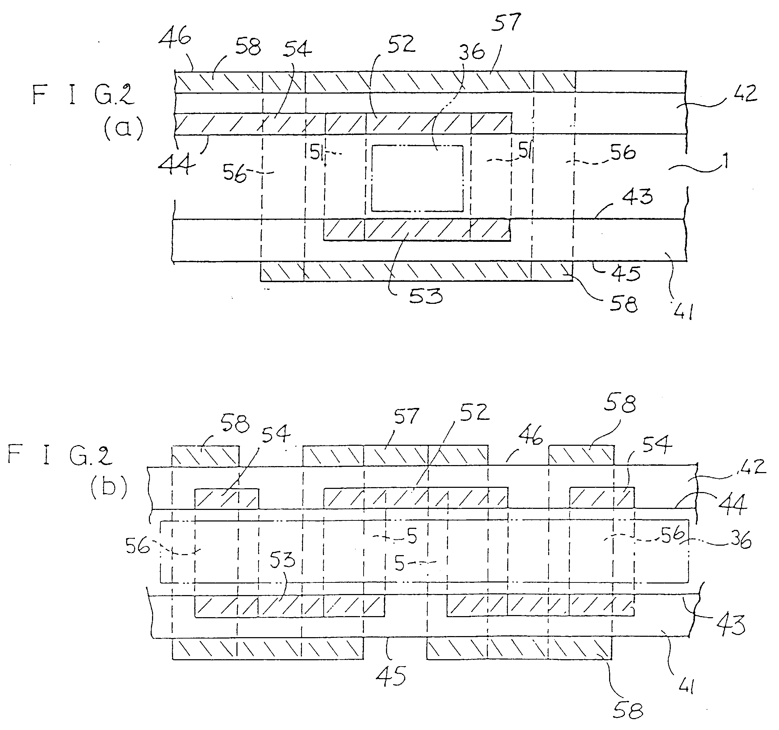

While the structure of Figure 1(a) provides good mutual coupling between the helical structures since they are so closely spaced, the coupling can be increased by including a material having a relatively high magnetic permeability within the two helices. An example of such a transformer is illustrated in Figures 2(a) and 2(b) which are side views similar to Figures 1(b) and 1(c). In addition to the elements shown in Figures 1(b) and 1(c), in the embodiment of the invention illustrated in Figures 2(a) and 2(b), a magnetic material 36, such as a ferrite, is disposed within substrate 1 inside helix 47. Magnetic body 36 is not limited to a ferrite and may include other magnetic materials, such as iron, ferrosilicon, or an iron/nickel alloy, for example. The magnetic material is a solid body that is disposed within a recess formed in substrate 1 before the conductors 52 and 53 are deposited. Alternatively, the magnetic material could be disposed in a recess by silk screening or some other material deposition process followed by any necessary curing steps.

## Claims

1. Method for producing a transformer integrable with a semiconductor integrated circuit, comprising the following steps:
- using an electrically insulating substrate (1) which includes a plurality of first via holes that penetrate said substrate (1) from a first surface (43) to a second surface (44) thereof;
- filling said first via holes with an electrically conducting material in order to obtain electrically conducting first vias (51);
- electrically connecting pairs of the first vias (51) by electrical conductors (53) disposed on the first surface (43) of said substrate (1) as well as pairs of the first vias (51) by electrical conductors (52) disposed on the second surface (44) of said substrate (1) in order to obtain a first generally helical coil (47);
- connecting two of the first vias (51) to respective leads (54) disposed on the second surface (44) of said substrate (1);
- placing electrically insulating layers (41, 42) on the first and second surfaces (43, 44) of the substrate (1), respectively;
- producing second via holes penetrating the insulating layers (41, 42) as well as the substrate (1);
- filling said second via holes with an electrically conducting material in order to obtain electrically conducting second vias (56);
- interconnecting by electrical conductors (58) pairs of the second vias (56) exposed at the outer surface (45) of the first insulating layer (41), and interconnecting by electrical conductors (57) pairs of the second vias (56) exposed at the outer surface (46) of the second electrically insulating layer (42) in order to obtain a second generally helical coil (48); and
- disposing two electrical leads (58a) on the outer surface (46) of the second insulating layer (42) respectively in contact with one of the second vias (56) to produce external leads.

2. The method as claimed in claim 1, further comprising the step of removing portions or all of the electrically insulating films (41, 42).

3. The method as claimed in claim 1 or 2, further comprising the step of disposing a magnetic material within the substrate inside the helical coil (47).

4. The method as claimed in claim 3, whereby the magnetic material is a solid body disposed within a recess formed in the substrate (1) before the conductors (52, 53) are deposited.

5. The method as claimed in claim 3, whereby the magnetic material is disposed in a recess by silk screening or some other material disposition process followed by any necessary curing steps.

## Patentansprüche

1. Verfahren zum Herstellen eines mit einem integrierten Halbleiterschaltkreis integrierbaren Transformators, mit folgenden Schritten:
- Benutzen eines elektrisch isolierenden Substrats (1), das eine Vielzahl von ersten Durchgangslöchern enthält, die das Substrat (1) von einer ersten Oberfläche (43) bis zu einer zweiten Oberfläche (44) durchdringen,
- Füllen der ersten Durchgangslöcher mit einem elektrisch leitenden Material, um elektrisch leitende erste Durchgänge (51) zu erhalten,
- elektrisches Verbinden von Paaren der ersten Durchgänge (51) durch elektrische Leiter (53), die auf der ersten Oberfläche (43) des Substrats (1) angeordnet sind, sowie von Paaren der ersten Durchgänge (51) durch elektrische Leiter (52), die auf der zweiten Oberfläche des Substrats (1) angeordnet sind, um eine erste im allgemeinen wendelförmige Wicklung (47) zu erhalten,
- Verbinden von zwei der ersten Durchgänge (51) mit jeweiligen Leitungen (54), die auf der zweiten Oberfläche (44) des Substrats (1) angeordnet sind,
- Anbringen elektrisch isolierender Schichten (41, 42) auf die erste bzw. zweite Oberfläche (43, 44) des Substrats (1),
- Herstellen zweiter Durchgangslöcher, die die isolierenden Schichten (41, 42) sowie das Substrat (1) durchdringen,
- Füllen der zweiten Durchgangslöcher mit einem elektrisch leitenden Material, um elektrisch leitende zweite Durchgänge (56) zu erhalten,
- Verbinden von Paaren der zweiten Durchgänge (56), die an der äußeren Oberfläche der ersten isolierenden Schicht (41) freiliegen, durch elektrische Leiter (58), und Verbinden von Paaren der zweiten Durchgänge (56), die auf der äußeren Oberfläche (46) der zweiten elektrisch isolierenden Schicht (42) freiliegen, durch elektrische Leiter (57), um eine zweite im allgemeinen wendelförmige Wicklung (48) zu erhalten, und
- Anordnen von zwei elektrischen Leitungen (58a) auf der äußeren Oberfläche der zweiten isolierenden Schicht (42), die jeweils in Kontakt mit einem der zweiten Durchgänge (56) sind, um äußere Leitungen herzustellen.

2. Verfahren nach Anspruch 1, **gekennzeichnet durch** Entfernen von Teilen oder allem der elektrisch isolierenden Filme (41, 42).

3. Verfahren nach Anspruch 1 oder 2, **gekennzeichnet durch** Anordnen von magnetischem Material in dem Substrat innerhalb der wendelförmigen Wicklung (47).

4. Verfahren nach Anspruch 3, **dadurch gekennzeichnet**, daß das magnetische Material ein fester Körper ist, der in einer Ausnehmung angeordnet ist, die in dem Substrat (1) ausgebildet ist, bevor die Leiter (52, 53) angeordnet werden.

5. Verfahren nach Anspruch 3, **dadurch gekennzeichnet**, daß das magnetische Material in der Ausnehmung durch Siebdruck oder einem anderen Materialauftragprozess gefolgt von erforderlichen Aushärt- oder Trocknungsschritten angeordnet wird.

## Revendications

1. Procédé pour produire un transformateur intégrable avec un circuit intégré semi-conducteur, comprenant les étapes suivantes :
- utiliser un substrat électriquement isolant (1) qui comprend un certain nombre de premiers trous traversants qui pénètrent ledit substrat (1) d'une première surface (43) à une seconde surface (44) de celui-ci ;
- remplir lesdits premiers trous traversants d'un matériau élastiquement conducteur afin d'obtenir des premiers conducteurs traversants électriquement conducteurs (51) ;
- électriquement relier des paires des premiers conducteurs traversants (51) par des conducteurs électriques (53) disposés sur la première surface (43) dudit substrat (1) ainsi que des paires des premiers conducteurs traversants (51) par des conducteurs électriques (52) disposés sur la seconde surface (44) dudit substrat (1) afin d'obtenir une première bobine généralement hélicoïdale (47) ;
- relier deux des premiers conducteurs traversants (51) à des conducteurs respectifs (54) disposés sur la seconde surface (44) dudit substrat (1) ;
- placer des couches isolantes électriquement (41, 42) respectivement sur les première et seconde surfaces (43, 44) du substrat (1) ;
- produire des seconds trous traversants pénétrant les couches isolantes (41, 42) ainsi que le substrat (1) ;
- remplir lesdits seconds trous traversants d'un matériau électriquement conducteur afin d'obtenir des seconds conducteurs traversants (56) électriquement conducteurs ;
- interconnecter par des conducteurs électriques (58) des paires des seconds conducteurs traversants (56) exposés à la surface externe (45) de la première couche isolante (41), et interconnecter par des conducteurs électriques (57) des paires des seconds conducteurs traversants (56) exposés à la surface externe (46) de la seconde couche électriquement isolante (42) afin d'obtenir une seconde bobine (48) généralement hélicoïdale ; et
- disposer deux conducteurs électriques (58a) sur la surface externe (46) de la seconde couche isolante (42) respectivement en contact avec l'un des seconds conducteurs traversants (56) pour produire des conducteurs externes.

2. Procédé comme revendiqué en revendication 1, **caractérisé par** retirer des portions des films électriquement isolants (41, 42) ou tous ceux-ci.

3. Procédé comme revendiqué en revendication 1 ou 2, **caractérisé par** l'étape de disposer un matériau magnétique dans le substrat à l'intérieur de la bobine hélicoïdale (47).

4. Procédé comme revendiqué en revendication 3, **caractérisé en ce que** le matériau magnétique est un corps solide disposé dans un évidemment formé dans le substrat (1) avant que les conducteurs (52, 53) soient déposés.

5. Procédé comme revendiqué en revendication 3, **caractérisé en ce que** le matériau magnétique est disposé dans un évidemment par sérigraphie ou autre procédé de dépôt de matériau suivi par toutes les étapes nécessaires de cuisson.
